# EUROPÄISCHE PATENTSCHRIFT

(11) **EP 1 052 777 B1**
(45) Veröffentlichungstag und Bekanntmachung des Hinweises auf die Patenterteilung: **04.06.2003**
(21) Anmeldenummer: 00104270.4
(22) Anmeldetag: 01.03.2000
(51) Int. Cl.: H03K 19/003, H03K 5/13, H03K 17/00, H03F 1/32, H03F 1/02, H03F 1/08, H03F 1/30, H04B 1/04, H03K 4/02, H03G 3/00, H03K 17/16

(54) **Verstärkerschaltvorrichtung**
Amplifying circuit device
Dispositif de circuit amplificateur

(30) Priorität: 05.03.1999 DE 19909772
(43) Veröffentlichungstag der Anmeldung: 15.11.2000
(73) Patentinhaber: Infineon Technologies AG, 81669 München (DE)
(72) Erfinder: Van Waasen, Stefan Dr., 47178 Duisburg (DE); Li Puma, Giuseppe, 44791 Bochum (DE)
(74) Vertreter: Epping Hermann & Fischer

(56) Entgegenhaltungen:
- EP-A- 0 233 626
- EP-A- 0 612 144
- US-A- 3 900 823
- US-A- 4 151 481
- US-A- 4 429 285
- US-A- 5 126 686
- US-A- 5 917 363

## Beschreibung

Die Erfindung betrifft eine Verstärkerschaltvorrichtung zum Schalten eines durch einen Referenzstrom gesteuerten Verstärkers.

Übertragungssysteme im Kommunikationsbereich verwenden verschiedene Multiplextechniken zur mehrfachen Ausnutzung eines Übertragungsweges durch mehrere Kanäle. Beim Frequenzmultiplexverfahren werden die einzelnen Kanäle in verschiedenen, nebeneinanderliegenden Frequenzbereichen gleichzeitig übertragen, während beim Zeitmultiplexverfahren die einzelnen Kanäle periodisch abgetastet und zeitlich nacheinander übertragen werden. Verschiedene Übertragungssysteme verwenden auch eine Kombination aus Frequenzmultiplex- und Zeitmultiplexverfahren.

Bei digitalen Zeitmultiplex-Übertragungssystemen, wie beispielsweise dem DECT (Digital European Cordless Telecommunications), wird der Kanal zum Senden und Empfangen von Informationen in eine Vielzahl von Rahmen (frame) unterteilt, wobei jeder Rahmen seinerseits wieder aus mehreren Zeitschlitzen (time slots) besteht. Beispielsweise besitzt das DECT-System Rahmen, die aus 24 Zeitschlitzen mit einer Dauer von je 416 Mikrosekunden bestehen. Von diesen 24 Zeitschlitzen sind 12 Zeitschlitze für den Empfangsbetrieb und die anderen 12 Zeitschlitze für den Sendebetrieb reserviert.

Zu Beginn eines aktiven Sendezeitschlitzes wird die Ausgangsverstärkerstufe eines Endgeräts des Übertragungssystems für den Sendebetrieb eingeschaltet. Hierzu muß die Ausgangsverstärkerstufe entsprechend dem jeweiligen Übertragungssystemstandard innerhalb eines vorbestimmten Zeitfensters auf eine vorbestimmte Sendeleistung hochgefahren werden, damit anschließend die Informationsdaten innerhalb des Zeitschlitzes ausgesendet werden können.

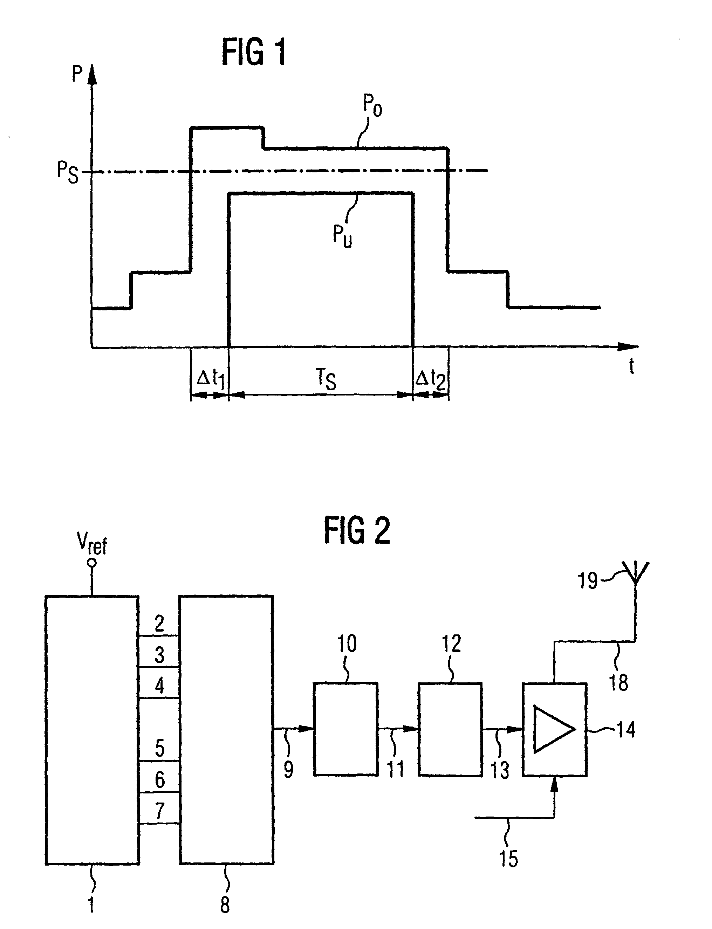

Fig. 1 zeigt schematisch ein Leistungsprofil für einen Zeitmultiplex-Übertragungsstandard. Die Ausgangsleistung P der Ausgangsverstärkerstufe muß sich innerhalb eines Korridors bewegen, welche durch eine obere zulässige Leistung PO und eine untere zulässige Leistung PU definiert ist. Gemäß dem Standard muß dabei die Sendeleistung der Ausgangsverstärkerstufe beim Einschalten innerhalb eines Zeitfensters Δt₁ von einer niedrigen Ausgangsleistung auf eine mittlere Sendeleistung Pₛ hochgefahren werden. Sobald die Sendeleistung Pₛ erreicht ist, können innerhalb eines Zeitfensters Tₛ Daten übertragen werden. Nach dem Senden wird die Ausgangsverstärkerstufe innerhalb eines Ausschaltzeitschlitzes Δt₂ wieder auf die niedrigere Leistung heruntergefahren. Bei dem DECT-Übertragungssystem beträgt die Dauer der beiden Zeitfenster beispielsweise 10 µs.

Das Hochfahren der Ausgangsverstärkerstufe während des Einschaltzeitschlitzes Δt₁ bzw. das Herunterfahren der Ausgangsverstärkerstufe während des Ausschaltzeitschlitzes Δt₂ darf jedoch nicht zum Aussenden von unerlaubten Störsignalen in ein benachbartes Frequenzspektrum führen. Das Signal sollte lediglich Frequenzanteile innerhalb eines vorbestimmten spektralen Fensters aufweisen, d.h. innerhalb einer niedrigen Grenzfrequenz fᵤ und einer oberen Grenzfrequenz fₒ. Aus diesem Grunde muß der Signalverlauf der Ausgangsleistung P der Ausgangsverstärkerstufe während des Einschalt- bzw. Ausschaltvorganges möglichst glatt und rund sein. Ein derartig glatter und runder Signalverlauf bedeutet, daß keine allzu hohen störenden hochfrequenten Signalanteile vorhanden sind.

Bei den bisherigen Übertragungssystemen wurde versucht, mittels eines externen Kondensators einen derartigen glatten und runden Signalverlauf beim Hoch- bzw. Herunterfahren der Ausgangsverstärkerstufe zu erreichen (z.B siehe Dokument EP-A-612144). Hierbei wird der externe Kondensator über einen Konstantstrom auf- bzw. entladen. Die Spannung an dem Kondensator steigt linear an und schaltet die Biasstufe für die Stromversorgung der Ausgangsverstärkerstufe ein bzw. aus. Der zeitliche Signalverlauf der Ausgangsleistung ist jedoch nicht genügend glatt, da der Stromanstieg in der Ausgangsverstärkerstufe durch die nichtlineare Transistorkennlinie vorgegeben ist. Bei Bipolartransistoren besteht beispielsweise ein exponentieller Zusammenhang zwischen Spannung und Strom. Die nichtlineare Transistorkennlinie führt zu störenden Signalanteilen im Frequenzspektrum.

Ein weiterer Nachteil derartiger Übertragungssysteme besteht darin, daß die Zeitfenster zum Ein- und Abschalten der Ausgangsverstärkerstufe nur sehr ungenau eingestellt werden können. Die Kapazität des Kondensators bestimmt zwar im wesentlichen die Zeitdauer des Ein- und Abschaltvorganges, jedoch unterliegt diese ebenfalls den Eigenschaften der nichtlinearen Transistorkennlinie. Bei vielen Anwendungen im Kommunikationsbereich, wie beispielsweise bei GSM, werden daher oft komplizierte Steuer- bzw. Regelverfahren eingesetzt, um die Probleme aufgrund der nichtlinearen Transistorkennlinie zu vermeiden. Derartige Steuerverfahren benötigen eine aufwendige digitale Steuerlogik.

Es ist daher die Aufgabe der vorliegenden Erfindung, eine Schaltvorrichtung zum Schalten der Verstärkerstufe zu schaffen, die einen glatten und runden Signalverlauf beim Ein- und Ausschalten der Verstärkerstufe gewährleistet, wobei die Zeitfenster zum Ein- und Ausschalten exakt einstellbar sind und die Schaltvorrichtung gleichzeitig mit einem geringen technischen Aufwand herstellbar ist.

Diese Aufgabe wird erfindungsgemäß durch eine Vorrichtung mit den im Patentanspruch 1 angegebenen Merkmalen gelöst.

Weitere vorteilhafte Ausgestaltungen der erfindungsgemäßen Schaltvorrichtung sind in den Unteransprüchen angegeben.

Die Erfindung schafft eine Schaltvorrichtung zum Schalten eines durch einen Referenzstrom gesteuerten Verstärkers mit
einem Spannungsteiler, der aus einer Referenzspannung eine Vielzahl unterschiedlicher Spannungspegel erzeugt,
einer Schaltlogik, durch welche die Spannungspegel zum Er2eugen einer Summenspannung aufsummierbar sind,
einer Filtereinrichtung, die die hochfrequenten Signalanteile der Summenspannung herausfiltert, und mit
einem Spannungsstromwandler, der die gefilterte Summenspannung in den Referenzstrom umwandelt.

Bei einer vorteilhaften Ausgestaltung der erfindungsgemäßen Schaltvorrichtung ist der Spannungsteiler ein Widerstandsnetzwerk.

Dies bietet den besonderen Vorteil, daß die unterschiedlichen Spannungspegel in einfacher und zuverlässiger Weise erzeugbar sind.

Bei einer weiteren vorteilhaften Ausgestaltung der erfindungsgemäßen Schaltvorrichtung besteht das Widerstandsnetzwerk aus einer Vielzahl von in Reihe geschalteten Widerständen.

Bei einer weiteren vorteilhaften Ausgestaltung der erfindungsgemäßen Schaltvorrichtung weist die Schaltlogik eine interne Zähleinrichtung auf.

Bei einer weiteren vorteilhaften Ausgestaltung der erfindungsgemäßen Schaltvorrichtung ist der Schaltlogik eine Abtast- und Halteschaltung nachgeschaltet.

Bei einer weiteren vorteilhaften Ausgestaltung der erfindungsgemäßen Schaltvorrichtung besteht die Filtereinrichtung aus mehreren in Serie geschalteten Pufferschaltungen und RC-Tiefpaßfiltern.

Bei einer weiteren vorteilhaften Ausgestaltung der erfindungsgemäßen Schaltvorrichtung wandelt der Spannungsstromwandler die Spannungsdifferenz zwischen der gefilterten Summenspannung und einem Referenzpotential in den Referenzstrom um.

Bei einer weiteren vorteilhaften Ausgestaltung der erfindungsgemäßen Schaltvorrichtung ist die Schaltlogik durch ein Steuersignal steuerbar, das zwischen einem ersten logischen Zustand zum Einschalten des Verstärkers und einem zweiten logischen Zustand zum Ausschalten des Verstärkers umschaltbar ist.

Bei einer weiteren vorteilhaften Ausgestaltung der erfindungsgemäßen Schaltvorrichtung sind die durch den Spannungsteiler erzeugten Spannungspegel jeweils einstellbar.

Bei einer weiteren vorteilhaften Ausgestaltung der erfindungsgemäßen Schaltvorrichtung verstärkt der Verstärker ein digitales Zeitmultiplexsignal.

Bei einer weiteren vorteilhaften Ausgestaltung der erfindungsgemäßen Schaltvorrichtung weist das durch den Verstärker verstärkte Zeitmultiplexsignal mehrere Zeitschlitze auf.

Bei einer weiteren vorteilhaften Ausgestaltung der erfindungsgemäßen Schaltvorrichtung besitzt jeder Zeitschlitz des verstärkten Zeitmultiplexsignals ein Einschaltzeitfenster und ein Ausschaltzeitfenster.

Bei einer weiteren vorteilhaften Ausgestaltung der erfindungsgemäßen Schaltvorrichtung ist der Verstärker innerhalb eines Zeitfensters umschaltbar.

Bei einer weiteren vorteilhaften Ausgestaltung der erfindungsgemäßen Schaltvorrichtung beträgt die Dauer eines Zeitfensters etwa 10 us.

Bei einer weiteren vorteilhaften Ausgestaltung der erfindungsgemäßen Schaltvorrichtung ist der Verstärker ein Sendesignalverstärker, welcher mit einer Sendeantenne verbunden ist.

Im weiteren wird eine bevorzugte Ausführungsform der erfindungsgemäßen Schaltvorrichtung unter Bezugnahme auf die beigefügten Zeichnungen zur Erläuterung erfindungswesentlicher Merkmale beschrieben.

Es zeigen:
- Fig. 1: eine schematische Ansicht eines Leistungspegelverlaufs eines Ausgangsverstärkers gemäß einem Übertragungssystem-Zeitmultiplexstandard;
- Fig. 2: ein schematisches Blockschaltbild der erfindungsgemäßen Schaltvorrichtung;
- Fig. 3: eine bevorzugte Ausführungsform der erfindungsgemäßen Schaltvorrichtung;
- Fig. 4: den Signalverlauf der durch die Schaltlogik erzeugten Summenspannung zur Erläuterung der Funktionsweise der erfindungsgemäßen Schaltvorrichtung.

Fig. 1 zeigt ein Ausgangsleistungspegeldiagramm, das ein Verstärker gemäß einem vordefinierten Zeitmultiplexstandard erfüllen muß. Der Ausgangs- bzw. Sendeverstärker muß dabei innerhalb eines Zeitfensters Δt₁ auf eine Sendeleistung Pₛ hochgefahren werden, damit innerhalb eines Zeitmultiplex-Zeitschlitzes mit der Zeitdauer Tₛ Signaldaten übertragen werden können. Beim Ausschalten muß der Ausgangsverstärker innerhalb eines Ausschalt-Zeitfensters Δt₂ von dem Signalleistungspegel Pₛ wieder heruntergefahren werden. Der Ausgangssignal-Leistungspegel des Verstärkers muß sich auf jeden Fall innerhalb eines Korridors bewegen, welcher durch eine untere Leistungspegellinie Pᵤ und eine obere Signalleistungspegellinie Pₒ bestimmt ist. Dabei muß das Ausgangsleistungssignal innerhalb des Einschaltzeitfensters Δt₁ und des Ausschaltzeitfensters Δt₂ einen möglichst glatten bzw. runden Signalverlauf nehmen, um störende Signalanteile zu vermeiden.

Fig. 2 zeigt ein Blockschaltbild der erfindungsgemäßen Schaltvorrichtung.

Die erfindungsgemäße Schaltvorrichtung weist einen Spannungsteiler 1 auf, der aus einer Referenzspannung V_{ref} eine Vielzahl unterschiedlicher Spannungspegel erzeugt. Die Spannungspegel werden über Leitungen 2, 3, 4, 5, 6, 7 einer Schaltlogik 8 zugeführt, durch welche die anliegenden Spannungspegel wahlweise zu einer Summenspannung aufsummierbar sind. Die Summenspannung wird über eine Leitung 9 einer Filtereinrichtung 10 zugeführt. Die Filtereinrichtung filtert die hochfrequenten Signalanteile der Summenspannung heraus.

Das durch die Filtereinrichtung 10 gefilterte Summenspannungssignal wird über ein Leitung 11 einem Spannungsstromwandler 12 zugeführt. Der Spannungsstromwandler 12 wandelt das gefilterte Summenspannungssignal in einen Referenzstrom um. Der Referenzstrom steuert über eine Leitung 13 einen Verstärker 14. Der Verstärker 14 verstärkt entsprechend dem Referenzstrom ein an einer Eingangsleitung 15 anliegendes Signal und gibt es verstärkt über eine Ausgangsleitung 18 an eine Sendeantenne 19 ab.

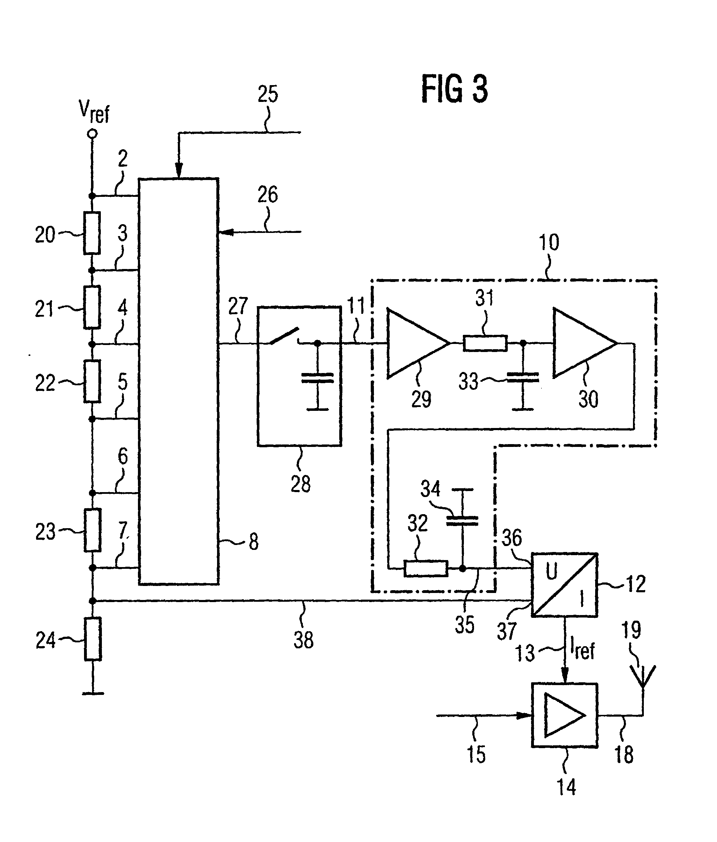

Fig. 3 zeigt eine bevorzugte Ausführungsform der erfindungsgemäßen Schaltvorrichtung.

Das in Fig. 2 gezeigte Widerstandsnetzwerk 1 besteht bei der in Fig. 3 gezeigten bevorzugten Ausführungsform aus einer Vielzahl von in Reihe geschalteten Widerständen 20, 21, 22, 23, 24. Die Anzahl der Widerstände kann beliebig hoch sein, so daß eine beliebig hohe Anzahl an unterschiedlichen Spannungspegeln erzeugt werden kann. Die Widerstandsleitfähigkeit der unterschiedlichen Widerstände 20, 21, 22, 23, 24 ist beliebig wählbar, so daß die Spannungspegel an den verschiedenen Leitungen 2, 3, 4, 5, 6, 7 voneinander unterschiedlich beabstandet sein können.

Bei einer bevorzugten Ausführungsform ist der Wert der Widerstände einstellbar bzw. steuerbar. Bei den Widerständen in dem Widerstandsnetzwerk 1 kann es sich um herkömmliche Ohmsche Widerstände, aber auch um Widerstände mit komplexen Anteilen handeln. Die Widerstände sind auch durch Halbleiterbauelemente realisierbar.

Die Schaltlogik 8 weist vorzugsweise eine interne Zähleinrichtung auf. Der Schaltlogik 8 wird über eine Taktsignalleitung 25 ein Taktsignal zugeführt, das durch eine Taktsignalerzeugungseinrichtung erzeugt wird.

Die Schaltlogik 8 weist vorzugsweise eine interne Zähleinrichtung auf, die über eine Steuerleitung 26 steuerbar ist. An der Steuerleitung 26 kann durch eine (nicht gezeigte) Steuerschaltung ein Steuersignal angelegt werden, das einen ersten Zustand zum Einschalten des Verstärkers 14 und einen zweiten logischen Zustand zum Ausschalten des Verstärkers 14 aufweist.

Die in der Steuerlogik 8 enthaltene Zähleinrichtung kann vorzugsweise einen Zählvorgang in beiden Richtungen durchführen, d.h. sie kann sowohl nach oben oder nach unten zählen.

Zum Einschalten des Verstärkers 14 wird an der Steuerleitung 26 ein logisches "1"-Signal angelegt, das die Zähleinrichtung dazu veranlaßt, entsprechend dem Taktsignal einen internen Zähler zu erhöhen. Der Zähler steuert eine in der Schaltlogik 8 enthaltene Schaltungseinrichtung derart, daß entsprechend dem internen Zähler die Spannung entsprechend dem Spannungsteiler 1 an der Ausgangsleitung 27 der Schaltlogik 8 erhöht wird.

Beispielsweise wird bei einem ersten Zähltakt der an der Leitung 7 anliegende Spannungspegel durchgeschaltet und bei jedem weiteren Takt die Spannung entsprechend den an den Widerständen 23, 22, 21, 20 anliegenden Spannung erhöht.

Bei der in Fig. 3 gezeigten bevorzugten Ausführungsform wird das an der Ausgangsleitung 27 der Schaltlogik 8 anliegende Summenspannungssignal durch einen Abtast-Halte-Schaltkreis 28 abgetastet. Durch den Abtast- und Halteschaltkreis 28 wird ein treppenförmiges Spannungssignal erzeugt, das der nachfolgenden Filtereinrichtung 10 über die Leitung 11 zugeführt wird.

Bei der in Fig. 3 gezeigten bevorzugten Ausführungsform besteht die Filtereinrichtung 10 aus zwei Filterstufen, wobei jede Filterstufe jeweils aus einem Pufferschaltkreis 29, 30 und einem RC-Tiefpaßfilter besteht. Die beiden RC-Tiefpaßfilter weisen jeweils einen Widerstand 31, 32 und einen Kondensator 33, 34 auf. Die Anzahl der in Reihe geschalteten Filterstufen kann entsprechend den Anforderungen gewählt werden. Auch Filterstufen aus rein passiven Bauelementen sind möglich.

Das durch die Filtereinrichtung 10 gefilterte Summenspannungssignal wird über eine Leitung 35 an einen ersten Eingang 36 des Spannungsstromwandler 12 angelegt. Der Spannungsstromwandler 12 verstärkt die Differenzspannung zwischen dem ersten Eingang 36 und einem zweiten Eingang 37, an dem über eine Leitung 38 die an dem Widerstand 24 abfallende Spannung angelegt ist. Die an dem Widerstand 24 abfallende Spannung dient als Referenzpotential.

Der Spannungsstromwandler 12 wandelt die zwischen den Anschlüssen 36, 37 anliegende Differenzspannung in einen Referenzstrom um, welcher über eine Leitung 13 dem Verstärker 14 zugeführt wird.

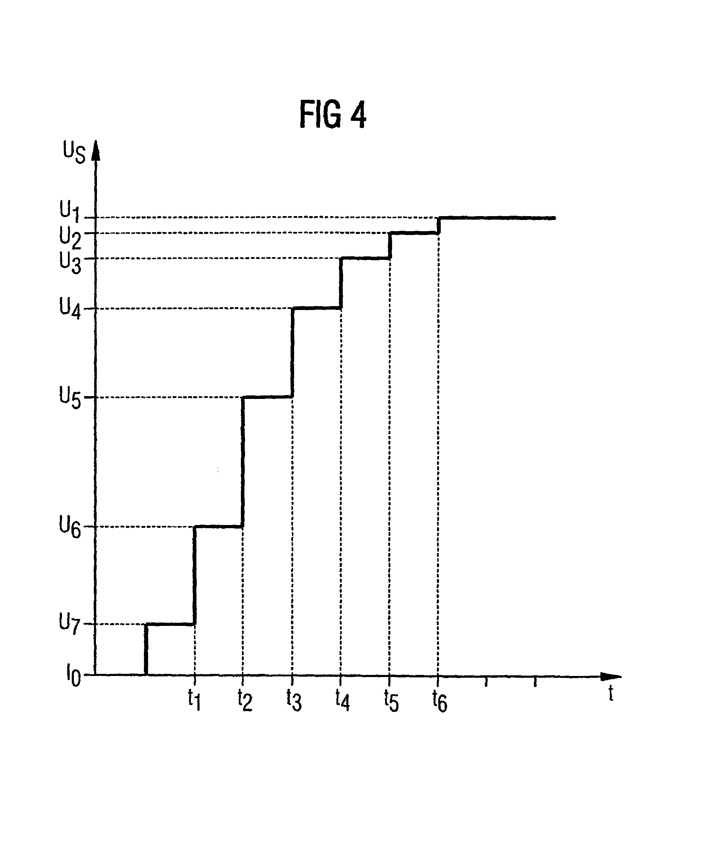

Fig. 4 zeigt beispielhaft den Signalverlauf der durch die Schaltlogik 8 und den Abtast-Halte-Schaltkreis 28 erzeugten treppenförmigen Summenspannungssignals.

Bei der in der Schaltlogik 8 vorhandenen internen Zähleinrichtung wird zunächst die an der Leitung 7 anliegende niedrige Spannung U₇ durchgeschaltet. Beim nächsten Takt wird die an der Leitung 6 anliegende Spannung U₆ durchgeschaltet und abgetastet. Bei jedem weiteren Takt erhöht sich die ausgangsseitige Spannung entsprechend der an den jeweiligen Widerständen abfallenden Spannung. Die Höhe der einzelnen Stufen ist durch die entsprechende Dimensionierung der Widerstände einstellbar. Durch entsprechende Dimensionierung der Widerstände 20, 21, 22, 23, 24 ist ein beliebiger stufenförmiger Signalverlauf realisierbar.

Das in Fig. 4 gezeigte treppenförmige Summenspannungssignal wird durch die Filtereinrichtung 10 gefiltert, wobei die hochfrequenten Anteile des treppenförmigen Signals herausgefiltert werden. Dadurch wird das treppenförmig verlaufende Signal abgeschliffen und die störenden hochfrequenten Signalanteile unterdrückt.

Der Spannungsstromwandler 12 wandelt das in Fig. 4 gezeigte Summenspannungssignal in einen entsprechenden Referenzstrom I_{ref} um, durch welchen der Verstärker 14 gesteuert wird.

Durch entsprechende Dimensionierung der Widerstände und der Referenzspannung V_{ref} ist es möglich, den Ausgangsspannungspegel des Verstärkers 14 derart zu steuern, daß er innerhalb des in Fig. 1 gezeigten Leistungskorridors einen beliebigen glatten Leistungspegelanstieg innerhalb des Zeitfensters Δt₁ erreicht.

Das Abschalten des Sendeverstärkers 14 während des Zeitfensters Δt₂ erfolgt entsprechend. Über die Steuerleitung 26 wird ein Signal mit dem logischen Zustand "0" an die Schaltlogik 8 angelegt. Dieses Signal mit dem logischen Wert "0" gibt an, daß der Verstärker 14 ausgeschaltet werden soll. Durch das an der Leitung 26 anliegende Signal wird die in der Schaltlogik 8 vorhandene interne Zähleinrichtung dazu veranlaßt, nach unten zu zählen, wobei die an der Ausgangsleitung 27 abgegebene Spannung schrittweise vermindert wird.

Durch die in Fig. 3 gezeigte bevorzugte Ausführungsform der erfindungsgemäßen Schaltvorrichtung ist es möglich, beliebige Signalverläufe des Ausgangssignal-Leistungspegels des Verstärkers 14 beim Ein- und Ausschalten zu realisieren. Es sind beispielsweise lineare, exponentielle oder gaußförmige Einschalt- und Ausschaltsignalverläufe realisierbar.

Der besondere Vorteil der in Fig. 3 gezeigten erfindungsgemäßen Schaltvorrichtung liegt darin, daß relativ komplizierte Signalverläufe durch eine einfache und robuste Schaltung realisiert werden.

Die in Fig. 3 gezeigte bevorzugte Ausführungsform der erfindungsgemäßen Schaltvorrichtung ist auch einfach als integrierte Schaltung umsetzbar. Die Widerstandsbauelemente, die Filterelemente und die Schaltelemente können als Halbleiterschaltbauelemente ausgeführt werden.

## Patentansprüche

1. Schaltvorrichtung zum Schalten eines durch einen Referenzstrom gesteuerten Verstärkers (14) mit
einem Spannungsteiler (1), der aus einer Referenzspannung eine Vielzahl unterschiedlicher Spannungspegel erzeugt,
einer Schaltlogik (8), durch welche die Spannungspegel zum Erzeugen einer Summenspannung aufsummierbar sind,
einer Filtereinrichtung (10), die die hochfrequenten Signalanteile der Summenspannung herausfiltert, und mit
einem Spannungsstromwandler (12), der die gefilterte Summenspannung in den Referenzstrom umwandelt.

2. Schaltvorrichtung nach Anspruch 1, **dadurch gekennzeichnet, daß** der Spannungsteiler (1) ein Widerstandsnetzwerk ist.

3. Schaltvorrichtung nach Anspruch 1 oder 2, **dadurch gekennzeichnet, daß** das Widerstandsnetzwerk aus einer Vielzahl von in Reihe geschalteten Widerständen (20, 21, 22, 23, 24) besteht.

4. Schaltvorrichtung nach einem der vorangehenden Ansprüche, **dadurch gekennzeichnet, daß** die Schaltlogik (8) eine interne Zähleinrichtung aufweist.

5. Schaltvorrichtung nach einem der vorangehenden Ansprüche, **dadurch gekennzeichnet, daß** der Schaltlogik (8) eine Abtast- und Halteschaltung (28) nachgeschaltet ist.

6. Schaltvorrichtung nach einem der vorangehenden Ansprüche, **dadurch gekennzeichnet, daß** die Filtereinrichtung (10) aus mehreren in Serie geschalteten Pufferschaltungen (29, 30) und Tiefpaßfiltern (31, 32; 32, 34) besteht.

7. Schaltvorrichtung nach einem der vorangehenden Ansprüche, **dadurch gekennzeichnet, daß** der Spannungsstromwandler (12) die Spannungsdifferenz zwischen der gefilterten Summenspannung und einem Referenzpotential in den Referenzstrom umwandelt.

8. Schaltvorrichtung nach einem der vorangehenden Ansprüche, **dadurch gekennzeichnet, daß** die Schaltlogik (8) durch ein Steuersignal steuerbar ist, das zwischen einem ersten logischen Zustand zum Einschalten des Verstärkers (14) und einem zweiten logischen Zustand zum Ausschalten des Verstärkers (14) umschaltbar ist.

9. Schaltvorrichtung nach einem der vorangehenden Ansprüche, **dadurch gekennzeichnet, daß** die Spannungspegel jeweils einstellbar sind.

10. Schaltvorrichtung nach einem der vorangehenden Ansprüche, **dadurch gekennzeichnet, daß** der Verstärker (14) ein digitales Zeitmultiplexsignal verstärkt.

11. Schaltvorrichtung nach Anspruch 10, **dadurch gekennzeichnet, daß** das Zeitmultiplexsignal mehrere Rahmen aufweist, die jeweils in Zeitschlitze unterteilt sind.

12. Schaltvorrichtung nach einem der vorangehenden Ansprüche, **dadurch gekennzeichnet, daß** der Zeitschlitz ein Einschaltzeitfenster und ein Ausschaltzeitfenster aufweist.

13. Schaltvorrichtung nach Anspruch 12, **dadurch gekennzeichnet, daß** der Verstärker (14) innerhalb eines Zeitfensters umschaltbar ist.

14. Schaltvorrichtung nach Anspruch 13, **dadurch gekennzeichnet, daß** die Dauer des Zeitfensters etwa 10 µs beträgt.

15. Schaltvorrichtung nach einem der vorangehenden Ansprüche, **dadurch gekennzeichnet, daß** der Verstärker (14) ein Sendesignalverstärker ist, dessen Ausgang mit einer Sendeantenne (19) verbunden ist.

## Claims

1. Switching device for switching an amplifier (14) controlled by a reference current having a voltage divider (1) which generates a multiplicity of different voltage levels from a reference voltage, a switching logic (8) which can sum the voltage levels in order to generate a sum voltage, a filter device (10) which filters out the high-frequency signal components of the sum voltage, and having a voltage/current converter (12) which transforms the filtered sum voltage into the reference current.

2. Switching device according to Claim 1, **characterized in that** the voltage divider (1) is a resistor network.

3. Switching device according to Claim 1 or 2, **characterized in that** the resistor network is composed of a multiplicity of resistors (20, 21, 22, 23, 24) which are connected in series.

4. Switching device according to one of the preceding claims, **characterized in that** the switching logic (8) has an internal counting device.

5. Switching device according to one of the preceding claims, **characterized in that** a sample-and-hold circuit (28) is connected downstream of the switching logic (8) .

6. Switching device according to one of the preceding claims, **characterized in that** the filter device (10) is composed of a plurality of buffer circuits (29, 30) and low-pass filters (31, 32; 32, 34) connected in series.

7. Switching device according to one of the preceding claims, **characterized in that** the voltage/current converter (12) transforms the voltage difference between the filtered sum voltage and a reference potential into the reference current.

8. Switching device according to one of the preceding claims, **characterized in that** the switching logic (8) can be controlled by means of a control signal which can be switched over between a first logic state for switching on the amplifier (14) and a second logic state for switching off the amplifier (14).

9. Switching device according to one of the preceding claims, **characterized in that** the voltage levels can each be adjusted.

10. Switching device according to one of the preceding claims, **characterized in that** the amplifier (14) amplifies a digital time-division multiplex signal.

11. Switching device according to Claim 10, **characterized in that** the time-division multiplex signal has a plurality of frames which are each divided into time slots.

12. Switching device according to one of the preceding claims, **characterized in that** the time slot has a switch-on time window and a switch-off time window.

13. Switching device according to Claim 12, **characterized in that** the amplifier (14) can be switched over within one time window.

14. Switching device according to Claim 13, **characterized in that** the duration of the time window is approximately 10 µs.

15. Switching device according to one of the preceding claims, **characterized in that** the amplifier (14) is a transmission signal amplifier whose output is connected to a transmission antenna (19).

## Revendications

1. Dispositif de connexion d'un amplificateur (14) commandé par un courant de référence comprenant
un diviseur (1) de tension qui produit une pluralité de tensions de niveaux différents à partir d'une tension de référence,
une logique (8) de commutation par laquelle les niveaux de tension peuvent être sommés pour produire une tension-somme,
un dispositif (10) de filtrage qui élimine par filtrage les composantes haute fréquence du signal de la tension-somme et
un convertisseur (12) tension-courant qui convertit la tension-somme filtrée en le courant de référence.

2. Dispositif de connexion suivant la revendication 1, **caractérisé en ce que** le diviseur (1) de tension est un réseau de résistances.

3. Dispositif de connexion suivant la revendication 1 ou 2, **caractérisé en ce que** le réseau de résistances est constitué d'une pluralité de résistances (20, 21, 22, 23, 24) montées en série.

4. Dispositif de connexion suivant l'une des revendications précédentes, **caractérisé en ce que** la logique (8) de commutation a un dispositif interne de comptage.

5. Dispositif de connexion suivant l'une des revendications précédentes, **caractérisé en ce qu'**un circuit (28) d'échantillonnage et de maintien est monté en aval de la logique (8) de commutation.

6. Dispositif de connexion suivant l'une des revendications précédentes, **caractérisé en ce que** le dispositif (10) de filtrage est constitué de plusieurs circuits (29, 30) tampons et de filtres passe-bas (31, 32 ; 32, 34) montés en série.

7. Dispositif de connexion suivant l'une des revendications précédentes, **caractérisé en ce que** le convertisseur (12) tension-courant convertit la différence de tension entre la tension-somme filtrée et un potentiel de référence en le courant de référence.

8. Dispositif de connexion suivant l'une des revendications précédentes, **caractérisé en ce que** la logique (8) de commutation peut être commandée par un signal de commande qui peut passer entre un premier état logique de mise en circuit de l'amplificateur (14) et un deuxième état logique de mise hors circuit de l'amplificateur (14).

9. Dispositif de- connexion suivant l'une des revendications précédentes, **caractérisé en ce que** les niveaux de tension peuvent être respectivement réglés.

10. Dispositif de connexion suivant l'une des revendications précédentes, **caractérisé en ce que** l'amplificateur (14) amplifié un signal numérique de multiplexage dans le temps.

11. Dispositif de connexion suivant la revendication 10, **caractérisé en ce que** le signal de multiplexage dans le temps comprend plusieurs trames qui sont subdivisées respectivement en créneaux temporels.

12. Dispositif de connexion suivant l'une des revendications précédentes, **caractérisé en ce que** le créneau temporel a une fréquence de temps de mise en circuit et une fenêtre de temps de mise hors circuit.

13. Dispositif de connexion suivant la revendication 12, **caractérisé en ce que** l'amplificateur (14) peut être commuté dans une fenêtre de temps.

14. Dispositif de connexion suivant la revendication 13, **caractérisé en ce que** la durée de la fenêtre de temps est d'environ 10 µs.

15. Dispositif de connexion suivant l'une des revendications précédentes, **caractérisé en ce que** l'amplificateur (14) est un amplificateur à signal d'émission dont la sortie est reliée à une antenne (19) d'émission.
